# EUROPÄISCHE PATENTSCHRIFT

(11) **EP 3 984 337 B1**
(45) Veröffentlichungstag und Bekanntmachung des Hinweises auf die Patenterteilung: **08.01.2025**
(21) Anmeldenummer: 20732560.6
(22) Anmeldetag: 10.06.2020
(51) Int. Cl.: H05K 5/00

(54) **EXPLOSIONSGESCHÜTZTES GEHÄUSE MIT EINEM VERSTÄRKUNGSRAHMEN**
EXPLOSION-PROOF HOUSING WITH A REINFORCING FRAME
BOITIER ANTIDÉFLAGRANT COMPORTANT UN CADRE DE RENFORCEMENT

(30) Priorität: 13.06.2019 DE 102019116164
(43) Veröffentlichungstag der Anmeldung: 20.04.2022
(73) Patentinhaber: R. Stahl Schaltgeräte GmbH, 74638 Waldenburg (DE)
(72) Erfinder: SEMRAU, Holger, 74589 Satteldorf (DE); KONDRUS, Elena, 74653 Künzelsau (DE)
(74) Vertreter: Rüger Abel Patentanwälte PartGmbB
(86) Internationale Anmeldenummer: PCT/EP2020/066100
(87) Internationale Veröffentlichungsnummer: WO 2020/249620

(56) Entgegenhaltungen:
- CN-A- 103 648 249
- CN-A- 106 803 647

## Beschreibung

Die Erfindung betrifft ein explosionsgeschütztes Gehäuse mit einem Innenraum, der explosionsgeschützt gegenüber der Umgebung des Gehäuses umschlossen ist. Im Innenraum können mögliche Zündquellen, die zu einer Zündung einer explosionsgefährdeten Atmosphäre in der Umgebung führen könnten, angeordnet werden. Zündquellen können beispielsweise elektrische und/oder elektronische Einrichtungen bzw. Betriebsmittel sein. Solche Einrichtungen bzw. Betriebsmittel können im Innenraum des explosionsgeschützten Gehäuses sicher betrieben werden. Das explosionsgeschützte Gehäuse verhindert ein Zünden der explosionsgefährdeten Atmosphäre in der Umgebung des Gehäuses außerhalb des Innenraums selbst dann, wenn im Innenraum Flammen, heiße Gase, Funken, Lichtbögen oder dergleichen entstehen.

US 2011/0303676 A1 offenbart ein explosionsgeschütztes Gehäuse mit metallischen Gehäusewänden. Wenigstens ein zusätzliches Verstärkungselement kann vorhanden sein, um die Stabilität der Gehäusewände zu verbessern. Das Verstärkungselement kann die Form eines Bügels haben. Mehrere Verstärkungselemente können über Gewindestäbe miteinander verbunden sein.

CN 203951114 U beschreib ein Gehäuse, das zur Verstärkung Versteifungsrippen an einem Gehäusedeckel aufweist.

CN 106803647 A beschreibt ein wasserdichtes Steuergehäuse. Der einen Gehäuseinnenraum umgebende Gehäusekörper ist über eine Mehrzahl von Dämpfungsfedern in einem Rahmen gelagert. Dadurch sollen Stöße gedämpft werden. Oberhalb des Gehäuses ist in einer Aussparung des Rahmens ein Wasseraufnahmetank vorhanden, um Wasser aufzunehmen und seitlich über Rohre über Steuergehäuse vorbei zu leiten. Auf diese Weise soll die Wasserdichtigkeit des Steuergehäuses verbessert werden.

CN 103648249 B betrifft ein explosionsgeschütztes Gehäuse mit einer Gehäuseöffnung, die von einer Dichtung 3 umschlossen ist. Eine Glasplatte 4 kann somit dichtend am Gehäuse angeordnet werden, um die Gehäuseöffnung zu schließen.

Grundsätzlich besteht bei explosionsgeschützten Gehäusen das Problem, dass die Gehäusestruktur und der damit zusammenhängende Zünddurchschlagsicherheit von Gehäusespalten und Öffnungen auch dann intakt bleiben muss, wenn im Innenraum des Gehäuses eine Explosion stattfindet und das Gehäuse schlagartig mit Druck beaufschlagt wird. Das explosionsgeschützte Gehäuse muss dem Explosionsdruck standhalten können ohne sich derart zu verformen bzw. ohne derart beschädigt zu werden, dass der explosionsgeschützte Zustand aufgehoben wird. Aus diesem Grund werden die Gehäusewände eines explosionsgeschützten Gehäuses üblicherweise sehr stabil ausgebildet. Beispielsweise können Gehäuse einen Gehäusekörper aus einem Gussteil aufweisen, das einen Innenraum begrenzt, wobei die Gehäuseöffnung im Gehäusekörper über einen entsprechend stabilen Deckel, insbesondere Stahldeckel, fest verschlossen wird. Solche explosionsgeschützten Gehäuse sind sehr schwer und aufgrund der eingesetzten Materialmenge sehr teuer.

Es kann daher als Aufgabe der Erfindung angesehen werden, ein explosionsgeschütztes Gehäuse zu schaffen, das sich einfach und kostengünstig herstellen lässt und gleichzeitig ein hohes Maß an Sicherheit bietet.

Diese Aufgabe wird durch ein explosionsgeschütztes Gehäuse mit den Merkmalen des Patentanspruches 1 gelöst.

Das erfindungsgemäße explosionsgeschützte Gehäuse hat einen Gehäusekörper, der einen Innenraum begrenzt. Der Gehäusekörper kann mehrere Gehäusewände aufweisen, die miteinander fest verbunden sein können, beispielsweise durch eine Haftverbindung oder eine stoffschlüssige Verbindung. Die Gehäusewände können miteinander durch Schweißen, Löten oder Kleben verbunden sein. An einer Seite hat der Gehäusekörper eine Gehäuseöffnung. Durch die Gehäuseöffnung ist der Zugang zum Innenraum ermöglicht. Im Innenraum kann wenigstens eine Zündquelle angeordnet sein, beispielsweise eine oder mehrere elektrische und/oder elektronische Einrichtungen oder Betriebsmittel. Mittels des explosionsgeschützten Gehäuses kann die wenigstens eine Zündquelle von einer explosionsgefährdeten Atmosphäre in der Umgebung des Gehäuses außerhalb des Innenraums getrennt werden.

Das explosionsgeschützte Gehäuse kann in einer geeigneten Zündschutzart ausgebildet sein. Vorzugsweise entspricht das explosionsgeschützte Gehäuse der Zündschutzart druckfeste Kapselung (Ex d) gemäß einer der Normen EN 60079-1 oder IIC 60079-1.

Das explosionsgeschützte Gehäuse hat einen Verstärkungsrahmen, der außen am Gehäusekörper angeordnet ist. Der Verstärkungsrahmen ist vollständig außerhalb des Innenraums angeordnet. Der Verstärkungsrahmen ist lösbar oder unlösbar am Gehäusekörper befestigt. Die lösbare Verbindung kann insbesondere durch eine Schraubverbindung gebildet sein. Die unlösbare Verbindung kann beispielsweise durch eine Haftverbindung oder eine stoffschlüssige Verbindung gebildet sein, beispielsweise durch Schweißen, Kleben, Löten oder eine beliebige Kombination davon. Die unlösbare Verbindung kann zusätzlich oder alternativ auch durch mechanische Mittel erfolgen, beispielsweise durch Nieten.

Der Verstärkungsrahmen bildet vorzugsweise eine zusammenhängende Struktur, die aus einzelnen Rahmenstreben gebildet sein kann. Die Rahmenstreben können als Hohlprofilstreben ausgebildet sein und insbesondere einen rechteckförmigen oder quadratischen oder anderen polygonalen Querschnitt aufweisen.

Zu dem explosionsgeschützten Gehäuse gehört außerdem ein Deckel. Der Deckel kann in eine Schließstellung gebracht werden. In der Schließstellung liegt der Deckel am Gehäusekörper an und begrenzt gemeinsam mit einem Abschnitt des Gehäusekörpers einen zünddurchschlagsicheren Spalt im Anschluss an die Gehäuseöffnung. Der zünddurchschlagsichere Spalt ist bevorzugt als ebener Spalt ausgebildet und kann sich entlang einer Ebene erstrecken. Durch den zünddurchschlagsicheren Spalt können Gase zwischen dem Innenraum und der Umgebung des Gehäuses strömen. Der durch den zünddurchschlagsicheren Spalt ermöglichte Gasströmungsweg ist derart dimensioniert, dass heiße Gase, Funken, Flammen, Lichtbögen oder dergleichen ausreichend gekühlt bzw. gelöscht werden, bevor sie vom Innenraum in die Umgebung gelangen. Dadurch ist sichergestellt, dass die explosionsgefährdete Atmosphäre in der Umgebung des Gehäuses nicht zünden kann, auch wenn im Innenraum des Gehäuses eine Explosion stattfindet oder Funken oder Flammen oder heiße Gase oder Lichtbögen entstehen. Um dies zu erreichen kann der zünddurchschlagsichere Spalt beispielsweise eine geringe Spaltquerschnittsfläche und rechtwinklig zur Spaltquerschnittsfläche eine ausreichend große Spaltlänge aufweisen.

Der Verstärkungsrahmen weist einen Ringrahmenteil auf, der die Gehäuseöffnung vollständig ringförmig umschließt. Dadurch, dass der Ringrahmenteil des Verstärkungsrahmens die Gehäuseöffnung vollständig ringförmig umschließt, ist insbesondere im Bereich des zünddurchschlagsicheren Spalts eine sehr gute Verstärkung des Gehäusekörpers erreicht. Wenn im Innenraum eine Explosion stattfindet, wird durch den Ringrahmenteil verhindert, dass sich der Gehäusekörper benachbart zum zünddurchschlagsicheren Spalt derart unerwünscht verformt, dass die Zünddurchschlagsicherheit beeinträchtigt bzw. aufgehoben wird.

Wegen des Verstärkungsrahmens können die Wände des Gehäusekörpers mit geringen Wandstärken ausgeführt werden, die ansonsten - ohne den Verstärkungsrahmen - dem Explosionsdruck nicht standhalten würden. Der Verstärkungsrahmen verstärkt den Gehäusekörper und stellt dadurch eine ausreichende Festigkeit bzw. Stabilität bereit, um auch im Falle einer Explosion im Innenraum den Explosionsschutz des Gehäuses zu gewährleisten.

Vorzugsweise ist der Verstärkungsrahmen oder zumindest der Ringrahmenteil des Verstärkungsrahmens nicht mit dem Deckel verbunden und/oder liegt nicht am Deckel an. Insbesondere dient der Verstärkungsrahmen nicht zur Begrenzung des zünddurchschlagsicheren Spalts. Der zünddurchschlagsichere Spalt wird zwischen dem Deckel und dem Gehäusekörper begrenzt.

Vorzugsweise weist das explosionsgeschützte Gehäuse wenigstens eine Druckentlastungseinrichtung auf. Die wenigstens eine Druckentlastungseinrichtung bildet wenigstens einen zünddurchschlagsicheren Gasströmungspfad zwischen dem Innenraum und der Umgebung. Der wenigstens eine zünddurchschlagsichere Gasströmungspfad ist zusätzlich zu dem Gasströmungsweg durch den zünddurchschlagsicheren Spalt vorhanden. Die wenigstens eine Druckentlastungseinrichtung kann in einer Wand des Gehäusekörpers und/oder im Deckel angeordnet sein.

Es ist außerdem vorteilhaft, wenn der Verstärkungsrahmen frei ist von Abschnitten des wenigstens einen zünddurchschlagsicheren Gasströmungspfades, der durch die wenigstens eine Druckentlastungseinrichtung gebildet ist. Rahmenstreben des Verstärkungsrahmens werden daher nicht durch den Gasströmungspfad durchsetzt.

Bei einer anderen Ausführungsform ist das explosionsgeschützte Gehäuse frei von Druckentlastungseinrichtungen. Eine Gasströmungsverbindung zwischen dem Innenraum und der Umgebung außerhalb des Gehäuses findet ausschließlich durch den zünddurchschlagsicheren Spalt statt.

Der Verstärkungsrahmen kann bei einer bevorzugten Ausführungsform wenigstens einen Rippenrahmenteil aufweisen, der mit dem Ringrahmenteil verbunden ist. Der Rippenrahmenteil erstreckt sich außerhalb einer Ebene, die durch den Ringrahmenteil definiert ist. Beispielsweise erstreckt sich der wenigstens eine Rippenrahmenteil entlang einer Ebene, die schräg oder rechtwinklig gegenüber der Ebene verläuft, entlang der sich die Gehäuseöffnung bzw. der Deckel erstreckt. Der wenigstens eine Rippenrahmenteil kann an einer oder an mehreren Stellen am Gehäusekörper anliegen. Der Rippenrahmenteil ragt vorzugsweise nicht in die Gehäuseöffnung hinein oder übergreift die Gehäuseöffnung auf der Seite, von der aus der Deckel am Gehäusekörper angeordnet wird, so dass der Zugang zum Innenraum durch den wenigstens einen Rippenrahmenteil nicht behindert wird.

Bei einem Ausführungsbeispiel kann jeder Rippenrahmenteil oder wenigstens ein Rippenrahmenteil der vorhandenen Rippenrahmenteile zwei Schenkel aufweisen, die sich mit Abstand zueinander erstrecken und jeweils mit dem Ringrahmenteil verbunden sind. Die Schenkel können rechtwinklig oder schräg vom Ringrahmenteil weg ragen. Die Schenkel des Rippenrahmenteils sind über einen Querschenkel des Rippenrahmenteils miteinander verbunden. Der Querschenkel ist mit Abstand zum Ringrahmenteil angeordnet. Dadurch kann der Rippenrahmenteil insbesondere eine U-Form oder eine V-Form oder eine Bügelform aufweisen.

Es ist außerdem vorteilhaft, wenn einer der beiden Schenkel und/oder der Querschenkel des wenigstens einen Rippenrahmenteils am Gehäusekörper anliegt. Der wenigstens eine Schenkel und/oder der Querschenkel kann dabei unmittelbar an einer benachbarten Gehäusewand des Gehäusekörpers anliegen oder mit der benachbarten Gehäusewand lösbar oder unlösbar verbunden sein.

Es ist außerdem bevorzugt, wenn mehrere Rippenrahmenteile vorhanden sind, die sich parallel zueinander erstrecken können. Die Rippenrahmenteile sind rechtwinklig zu ihrer jeweiligen Erstreckungsebene mit Abstand zueinander angeordnet. Der Gehäusekörper kann dadurch in definierten Abständen durch die Rippenrahmenteile abgestützt werden.

Bei einem anderen Ausführungsbeispiel des explosionsgeschützten Gehäuses kann der Verstärkungsrahmen ausschließlich durch den Ringrahmenteil gebildet sein.

Der wenigstens eine Rippenrahmenteil und/oder der Ringrahmenteil kann jeweils aus mehreren miteinander verbundenen Rahmenstreben gebildet sein. Unmittelbar benachbarte Rahmenstreben liegen vorzugsweise aneinander an bzw. sind lösbar oder unlösbar miteinander verbunden. Insbesondere können unmittelbar benachbarte Rahmenstreben mit ihren beiden einander zugeordneten Enden aneinander anliegen oder mittels einer Haftvermittlungsschicht oder einer Stoffschluss-Verbindungsschicht miteinander verbunden sein, beispielsweise durch Kleben, Schweißen oder Löten. Unmittelbar benachbarte Rahmenstreben können auch auf andere beliebige Weise lösbar oder unlösbar miteinander verbunden sein. Eine unlösbare Verbindung kann zusätzlich oder alternativ zu einer Haftverbindung und/oder stoffschlüssigen Verbindung auch durch mechanische Mittel hergestellt werden, beispielsweise durch Nieten.

Es ist außerdem vorteilhaft, wenn der Gehäusekörper einen Gehäuseflansch aufweist. Der Gehäuseflansch erstreckt sich vorzugsweise vollständig um die Gehäuseöffnung herum. Der Gehäuseflansch begrenzt gemeinsam mit einem gegenüberliegenden Randbereich des Deckels den zünddurchschlagsicheren Spalt. Der Randbereich des Deckels liegt vorzugsweise unmittelbar am Gehäuseflansch an. Bevorzugt werden der Deckel und der Gehäuseflansch durch geeignete Verbindungsmittel, beispielsweise Schrauben oder Klemmen, gegeneinander gedrückt, wenn sich der Deckel in der Schließstellung befindet.

Der Gehäuseflansch kann sich bevorzugt am Ringrahmenteil abstützen, insbesondere unmittelbar am Ringrahmenteil anliegen. Dabei kann der Gehäuseflansch zwischen dem Ringrahmenteil und dem Deckel angeordnet sein. Der Gehäuseflansch kann in Umfangsrichtung um die Gehäuseöffnung über seine gesamte Umfangslänge und/oder quer dazu über seine gesamte Breite am Ringrahmenteil anliegen. Zusätzlich oder alternativ kann der Ringrahmenteil an einer oder mehreren Stellen an einer oder mehreren sich an den Gehäuseflansch anschließenden Seitenwand bzw. Seitenwänden des Gehäusekörpers anliegen.

Vorteilhafte Ausgestaltungen der Erfindung ergeben sich aus den abhängigen Patentansprüchen, der Beschreibung und den Zeichnungen. Nachfolgend werden bevorzugte Ausführungsbeispiele der Erfindung anhand der beigefügten Zeichnungen im Einzelnen erläutert. Die Zeichnungen zeigen:
Figur 1 ein Ausführungsbeispiel eines explosionsgeschützten Gehäuses in einer perspektivischen Ansicht mit Blick schräg auf einen Deckel des explosionsgeschützten Gehäuses,
Figur 2 das Ausführungsbeispiel des explosionsgeschützten Gehäuses aus Figur 1 in einer andere perspektivischen Darstellung mit Blick schräg auf eine dem Deckel entgegengesetzte Rückseite des explosionsgeschützten Gehäuses,
Figur 3 eine vergrößerte Teildarstellung eines Eckbereichs III des explosionsgeschützten Gehäuses aus Figur 2,
Figur 4 ein Schnittbild durch den Eckbereich des explosionsgeschützten Gehäuses aus Figur 3,
Figur 5 eine Seitenansicht eines Ausführungsbeispiels eines explosionsgeschützten Gehäuses,
Figur 6 eine schematische Prinzipdarstellung einer Druckentlastungseinrichtung zur Bildung eines Gasströmungspfades zwischen einem Innenraum des Gehäuses und einer Umgebung außen um das Gehäuse herum,
Figur 7 ein weiteres Ausführungsbeispiel eines explosionsgeschützten Gehäuses in einer perspektivischen Explosionsdarstellung und
Figur 8 ein weiteres Ausführungsbeispiel eines explosionsgeschützten Gehäuses in einer perspektivischen Darstellung.

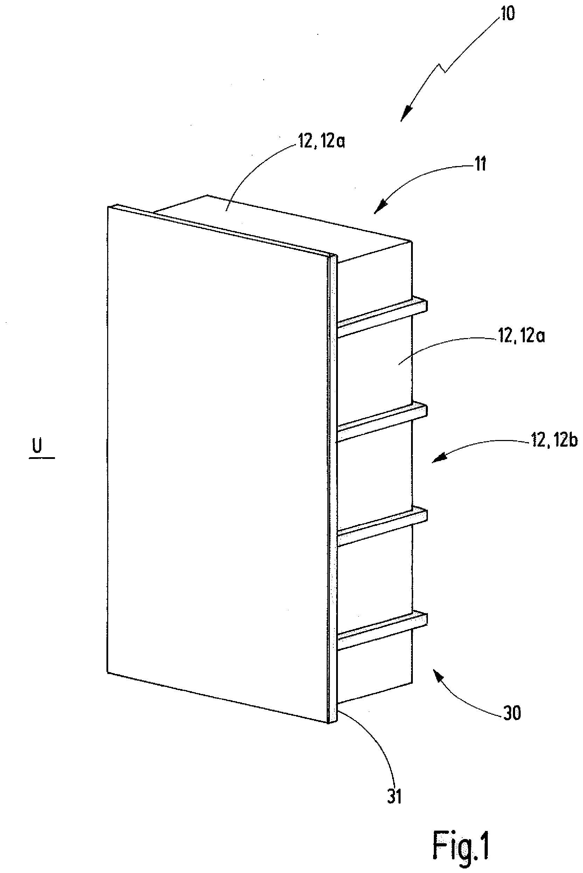

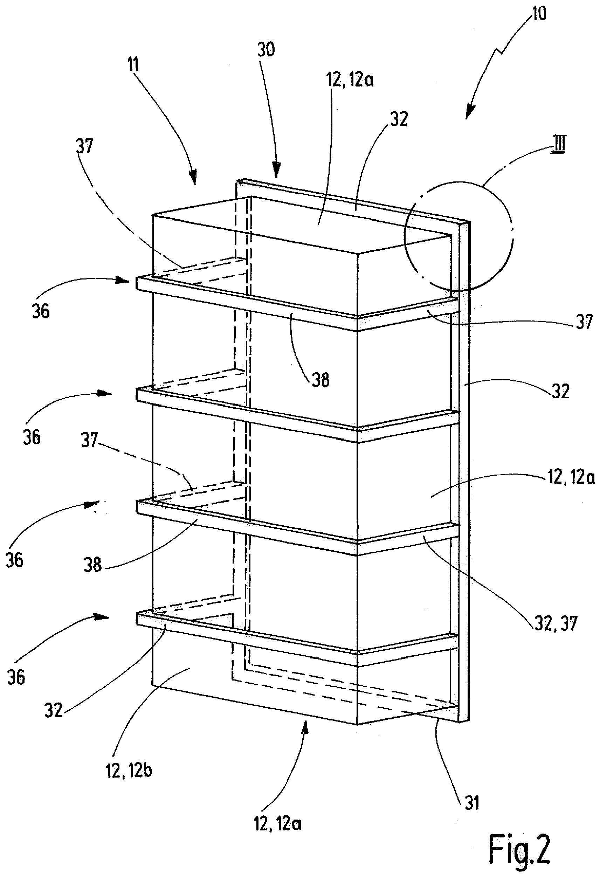

In den Figuren 1, 2, 5, 7 und 8 sind unterschiedliche Ausführungsbeispiele eines explosionsgeschützten Gehäuses 10. Das explosionsgeschützte Gehäuse 10 hat einen Gehäusekörper 11, der eine oder mehrere Gehäusewände 12 aufweist. Beim Ausführungsbeispiel weist der Gehäusekörper eine oder mehrere Seitenwände 12a sowie eine Rückwand 12b auf. Die Anzahl der Seitenwände 12a kann abhängig von der Form des Gehäusekörpers 11 variieren. Beispielsweise kann auch eine einzige kreisringförmige Seitenwand 12a vorhanden sein. Bei dem hier beschriebenen bevorzugten Ausführungsbeispielen hat der Gehäusekörper 11 vier Seitenwände 12a und eine im Wesentlichen quaderförmige Kontur.

Alle vorhandenen Seitenwände 12a sind mit der Rückwand 12b verbunden. Die Gehäusewände 12 sind bei den hier veranschaulichten Ausführungsbeispielen unlösbar miteinander verbunden. Vorzugsweise sind die Gehäusewände 12 durch eine Haftverbindung oder stoffschlüssige Verbindung miteinander verbunden, beispielsweise durch Kleben, Schweißen, Löten oder eine Kombination davon.

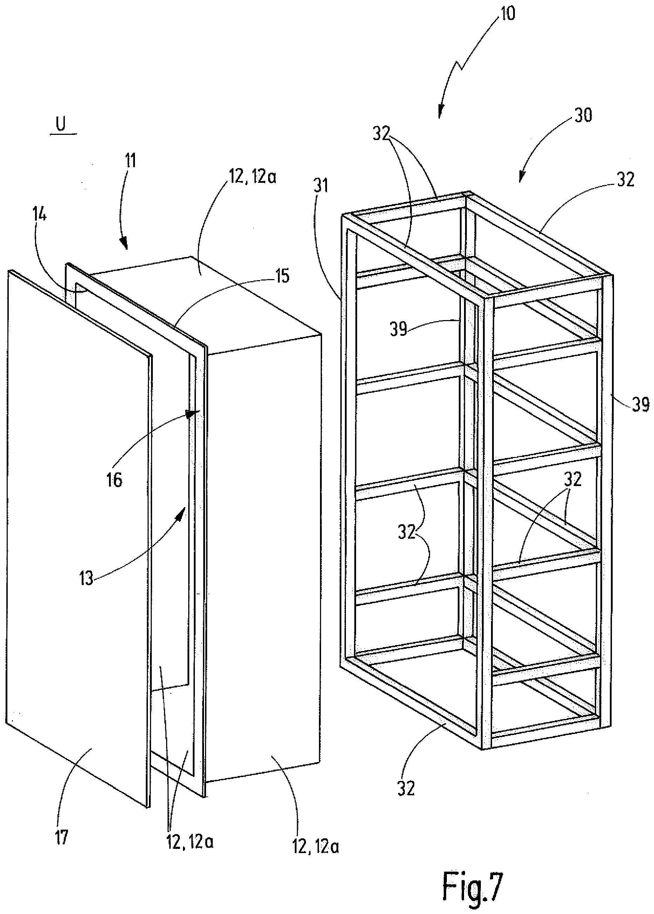

Der Gehäusekörper 11 begrenzt einen Innenraum 13 des explosionsgeschützten Gehäuses, der in Figur 7 zu erkennen ist. Im Innenraum 13 können potentielle Zündquellen aufgenommen werden. Solche potentiellen Zündquellen können beispielsweise elektrische und/oder elektronische Einrichtungen bzw. Betriebsmittel sein.

Der Innenraum 13 ist mittels einer Gehäuseöffnung 14 an einer Seite zugänglich. Die Gehäuseöffnung 14 befindet sich beispielsgemäß auf der der Rückwand 12b entgegengesetzten Seite des Gehäusekörpers 11 und wird vom Gehäusekörper 11 begrenzt. Am Gehäusekörper 11 ist ein Gehäuseflansch 15 vorhanden, der die Gehäuseöffnung 14 bei den hier beschriebenen und veranschaulichten Ausführungsbeispielen vollständig umschließt. Der Gehäuseflansch 15 hat beim Ausführungsbeispiel mehrere Abschnitte, wobei sich jeder Abschnitt des Gehäuseflanschs 15 an jeweils einer Seitenwand 12a des Gehäusekörpers 11 anschließt.

Jeder Abschnitt des Gehäuseflanschs 15 kann beim Ausführungsbeispiel integral mit jeweils einer Gehäusewand bzw. Seitenwand 12a ausgebildet sein oder kann durch Haftverbindung oder durch eine stoffschlüssige Verbindung mit der sich anschließenden Seitenwand 12a verbunden sein. Die Abschnitte des Gehäuseflanschs 15, die sich in Umfangsrichtung um die Gehäuseöffnung 14 aneinander anschließen, sind entweder integral ausgebildet oder durch eine stoffschlüssige Verbindung oder Haftverbindung miteinander verbunden.

Wenn in der vorliegenden Anmeldung eine stoffschlüssige Verbindung oder eine Haftverbindung erwähnt ist, kann diese Verbindung beispielsweise durch Schweißen und/oder Kleben und/oder Löten hergestellt sein.

Der Gehäuseflansch 15 ragt von der Gehäuseöffnung 14 ausgesehen nach außen weg und nicht in die Gehäuseöffnung 14 hinein. Der Gehäuseflansch 15 bildet eine erste Begrenzungsfläche 16, die sich vorzugsweise entlang einer Ebene erstreckt.

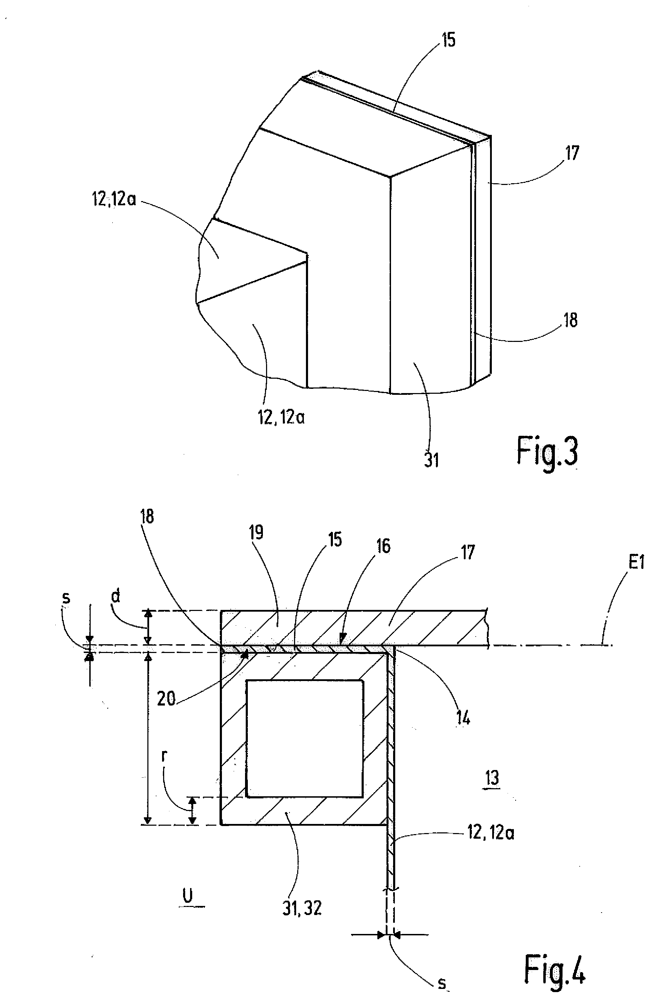

Um den Innenraum 13 explosionsgeschützt bzw. zünddurchschlagsicher von der Umgebung 14 zu trennen, weist das explosionsgeschützte Gehäuse 10 außerdem einen Deckel 17 auf. In einer Schließstellung (Figuren 1, 2, 3, 5 und 8) liegt der Deckel 17 derart am Gehäusekörper 11 und beispielsgemäß am Gehäuseflansch 15 an, dass zwischen dem Deckel 17 und dem Gehäusekörper 11 ein zünddurchschlagsicherer Spalt 18 gebildet ist (Figuren 3, 4, 5 und 8).

Zur Bildung des zünddurchschlagsicheren Spalts 18 liegt dem Gehäuseflansch 15 ein Randbereich 19 des Deckels 17 gegenüber, an dem eine zweite Begrenzungsfläche 20 gebildet ist. Der zünddurchschlagsichere Spalt 18 ist durch die erste Begrenzungsfläche 16 am Gehäuseflansch 15 und die zweite Begrenzungsfläche 20 am Randbereich 19 des Deckels 17 begrenzt. In der Schließstellung des Deckels 17 werden der Deckel 17 und der Gehäuseflansch 15 und somit die erste Begrenzungsfläche 16 und die zweite Begrenzungsfläche 20 gegeneinander gedrückt. Die Kraft hierfür kann durch entsprechende Verbindungsmittel erzeugt werden, wie etwa Schrauben und/oder Klemmen oder ähnliches. Die den zünddurchschlagsicheren Spalt 18 begrenzenden Begrenzungsflächen 16, 20 sind in Figur 4 veranschaulicht.

In Figur 4 ist außerdem zu erkennen, dass sich die erste Begrenzungsfläche 16 und die zweite Begrenzungsfläche 20 parallel zueinander in einer ersten Ebene E1 erstrecken, wenn sich der Deckel 17 in der Schließstellung befindet. Der zünddurchschlagsichere Spalt 18 befindet sich daher ebenfalls in dieser ersten Ebene E1.

Um den Gehäusekörper 11 möglichst leicht mit wenigem Materialaufwand bauen zu können, ist die Wandstärke s der Gehäusewände 12 bzw. des Flansches 15 klein und beim Ausführungsbeispiel deutlich kleiner als die Dicke d des Deckels 17 (Figur 4). Die Wandstärke s der Gehäusewände 12 und des Flansches 15 kann beispielsweise mindestens 3 bis 4 Mal kleiner sein als die Dicke d des Deckels 17. Um den Gehäusekörper 11 zu stabilisieren, so dass dieser einem Explosionsdruck im Innenraum 13 des explosionsgeschützten Gehäuses 10 standhält, weist das explosionsgeschützte Gehäuse einen Verstärkungsrahmen 30 auf. Der Verstärkungsrahmen 30 ist lösbar oder unlösbar mit dem Gehäusekörper 11 verbunden. Zur lösbaren Verbindung kann der Verstärkungsrahmen 30 mit dem Gehäusekörper 11 durch eine Schraubverbindung oder eine andere formschlüssige und/oder kraftschlüssige Verbindung verbunden sein. Bevorzugt ist der Verstärkungsrahmen 30 unlösbar mit dem Gehäusekörper 11 verbunden, beispielsweise durch eine stoffschlüssige Verbindung und/oder eine Haftverbindung, wie beispielsweise durch Schweißen und/oder Löten und/oder Kleben. Zusätzlich oder alternativ kann der Verstärkungsrahmen 30 auch durch eine Nietverbindung mit dem Gehäusekörper 11 verbunden sein.

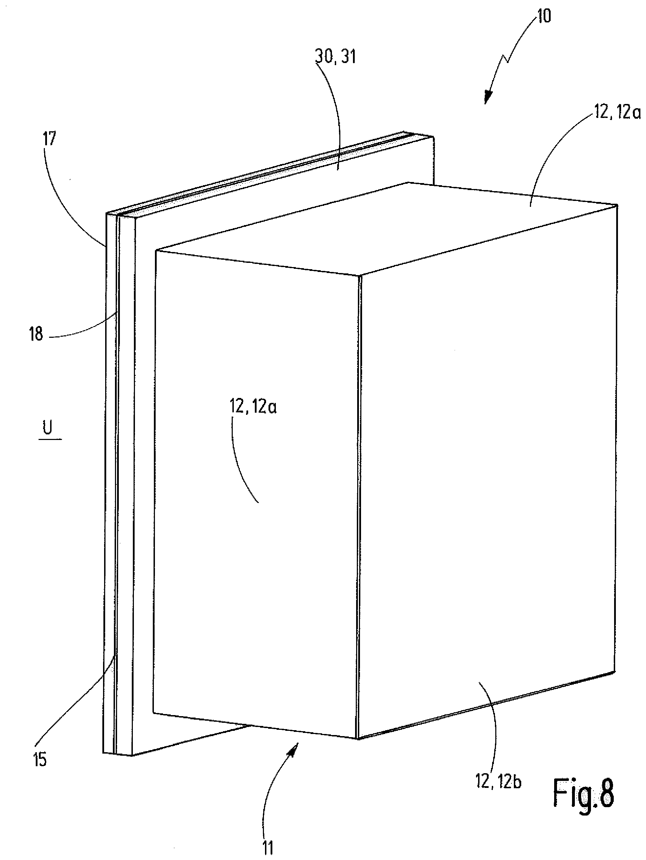

Der Verstärkungsrahmen 30 weist einen sich benachbart zum zünddurchschlagsicheren Spalt 18 vollständig um die Gehäuseöffnung 14 herum erstreckenden Ringrahmenteil 31 auf. Im einfachsten Fall kann der Verstärkungsrahmen 30 durch den Ringrahmenteil 31 gebildet sein (Figur 8).

Der Verstärkungsrahmen 30 ist außerhalb des Innenraums 13 angeordnet und außen mit dem Gehäusekörper 11 verbunden. Ein direkter Kontakt und/oder eine direkte Verbindung zwischen dem Verstärkungsrahmen 30 und dem Deckel 17 besteht beim Ausführungsbeispiel nicht. Zwischen dem Ringrahmenteil 31 des Verstärkungsrahmens 30 und dem Deckel 17 ist der Flansch 15 angeordnet und trennt daher den Ringrahmenteil 31 vom Deckel 17, so dass eine direkte Verbindung bzw. ein direkter Kontakt nicht besteht. Es ist allerdings möglich, dass der Verstärkungsrahmen 30 dazu eingerichtet ist, mit einem Verbindungsmittel zusammenzuwirken, um den Deckel 17 in seiner Schließstellung am Gehäusekörper 11 zu befestigen. Beispielsweise können an dem Verstärkungsrahmen 30 bzw. dem Ringrahmenteil 31 Angriffsflächen für Klemmen oder Zwingen vorhanden sein. Zusätzlich oder alternativ können am Verstärkungsrahmen 30 bzw. dem Ringrahmenteil 31 Gewindeaufnahmen für Gewindebolzen vorhanden sein, mittels denen der Deckel 17 in seiner Schließstellung gehalten wird.

In der Zeichnung, beispielsweise in den Figuren 3 und 4, ist auch zu erkennen, dass der Ringrahmenteil 31 den Gehäuseflansch 15 entlang seiner gesamten Umfangslänge in Umfangsrichtung um die Gehäuseöffnung 14 abstützt. Der Ringrahmenteil 31 kann den Gehäuseflansch 15 quer zur Umfangsrichtung entlang seiner gesamten Breite (Figuren 3 und 4) oder nur entlang eines Abschnitts abstützen. Der Ringrahmenteil 31 liegt bevorzugt zumindest an einer oder mehreren Stellen oder entlang seiner gesamten Erstreckung an den sich an den Gehäuseflansch 15 anschließenden Seitenwänden 12a des Gehäusekörpers 11 an.

Der Ringrahmenteil 31 bzw. der Verstärkungsrahmen 30 ist beispielsgemäß durch mehrere Rahmenstreben 32 gebildet, die vorzugsweise jeweils als Hohlprofilstreben ausgebildet sind (Figur 4). Die Rahmenstreben 32 haben vorzugsweise eine polygonale Querschnittskontur, die beim Ausführungsbeispiel quadratisch oder rechteckförmig sein kann. Die Rahmenstreben 32 haben eine Rahmenwandstärke r, die größer ist als die Wandstärke s der Gehäusewände 12 bzw. des Gehäuseflanschs 15. Die Rahmenwandstärke r kann kleiner sein als die Dicke d des Deckels 17 oder in etwa gleich groß wie die Dicke d des Deckels 17.

Zur Bildung des Ringrahmenteils 31 sind mehrere Rahmenstreben 32 und beispielsgemäß vier Rahmenstreben 32 miteinander verbunden. Jeweils zwei unmittelbar benachbarte Rahmenstreben sind dabei mit ihren einander zugeordneten Enden, z.B. durch eine stoffschlüssige Verbindung und/oder eine Haftverbindung miteinander verbunden. Der Ringrahmenteil 31 hat beim Ausführungsbeispiel eine rechteckförmige Gestalt. Bei zylindrischen Gehäuseteilen 11 kann der Ringrahmenteil 31 auch eine kreisrunde Form aufweisen und durch wenigstens eine, einen geschlossenen Kreisring bildende Rahmenstrebe 32 gebildet sein.

Bei den Ausführungsbeispielen gemäß den Figuren 1-7 weist der Verstärkungsrahmen 30 zusätzlich zu dem Ringrahmenteil 31 wenigstens einen Rippenrahmenteil 36 auf. Bei den Ausführungsbeispielen gemäß der Figuren 1, 2 und 5 sind vier Rippenrahmenteile 36 vorhanden. Beim Ausführungsbeispiel der Figur 7 sind sechs Rippenrahmenteile 36 vorhanden. Die Anzahl der Rippenrahmenteile 36 kann abhängig von der Größe des Gehäusekörpers 11 variieren.

Jedes Rippenrahmenteil 36 hat zwei Schenkel 37, die mit Abstand zueinander angeordnet sind und beispielsweise parallel zueinander angeordnet sein können. Jeder der beiden Schenkel 37 ist mit dem Ringrahmenteil 31 verbunden, beispielsweise durch eine Haftverbindung und/oder eine stoffschlüssige Verbindung. Die beiden Schenkel 37 sind bezüglich der Gehäuseöffnung 14 bzw. bezüglich des Gehäusekörpers 11 aufeinander gegenüberliegenden bzw. entgegengesetzten Seiten angeordnet.

Mit Abstand zum Ringrahmenteil 31 und beispielsgemäß an den dem Ringrahmenteil 31 entgegengesetzten Enden sind die beiden Schenkel 37 eines gemeinsamen Rippenrahmenteils 36 mittels eines Querschenkels 38 miteinander verbunden. Der Querschenkel 38 kann beispielsweise durch eine stoffschlüssige Verbindung und/oder eine Haftverbindung mit den Schenkeln 37 verbunden sein.

Somit hat der wenigstens eine Rippenrahmenteil 36 beim Ausführungsbeispiel eine bügelförmige Gestalt. Die beiden Schenkel 37 müssen abweichend zum bevorzugten Ausführungsbeispiel nicht zwingend parallel zueinander ausgerichtet sein. Vorzugsweise erstrecken sich die Schenkel 37 entlang und parallel zur unmittelbar benachbarten Seitenwand 12a des Gehäusekörpers 11 und sind in ihrer Erstreckung an die Gestalt der Seitenwand 12a angepasst.

Bei dem in den Figuren 1, 2 und 5 veranschaulichten Ausführungsbeispiel sind die Rippenrahmenteile 36 ausschließlich über den gemeinsamen Ringrahmenteil 31 des Verstärkungsrahmens 30 miteinander verbunden. Zusätzliche Rahmenstreben 32, die zwischen den Rippenrahmenteilen 36 verlaufen und nicht zum Ringrahmenteil 31 gehören, können entfallen.

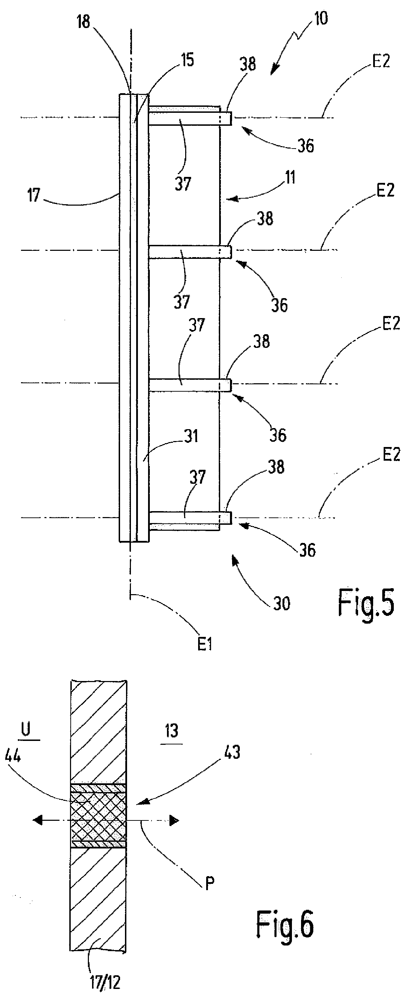

Die Rippenrahmenteile 36 erstrecken sich jeweils in einer zweiten Ebene E2, wobei jede zweite Ebene E2 beim Ausführungsbeispiel rechtwinklig zur ersten Ebene E1 ausgerichtet ist (vergleiche z.B. Figur 5). Rechtwinklig zu den zweiten Ebenen E2 sind die Rippenrahmenteile 36 mit Abstand zueinander angeordnet. Die Abstände zwischen zwei unmittelbar benachbarten Rippenrahmenteilen 36 können jeweils gleich groß sein (Figuren 1, 2 und 5). Die Abstände zwischen jeweils zwei unmittelbar benachbarten Rippenrahmenteilen 36 rechtwinklig zu der jeweiligen Erstreckungsebene (zweite Ebene E2) können auch unterschiedlich groß sein, wie es in Figur 7 gezeigt ist.

Bei dem in Figur 7 dargestellten Ausführungsbeispiel sind die Rippenrahmenteile 36 durch zusätzliche Rahmenverbindungen 39 des Verstärkungsrahmens 30 unabhängig vom Ringrahmenteil 31 miteinander verbunden. Beispielsgemäß sind zwei durch jeweils wenigstens eine Rahmenstrebe 32 gebildete Rahmenverbindung 39 vorhanden, die sich parallel zur ersten Ebene 1 bzw. parallel zum Ringrahmenteil 31 erstrecken und die Rippenrahmenteile 36 in den Eckbereichen zwischen einem Schenkel 37 und dem Querschenkel 38 miteinander verbinden. Beim Ausführungsbeispiel sind zwei sich parallel zueinander erstreckenden Rahmenverbindungen 39 vorhanden, an denen jeweils die Querschenkel 38 und die Schenkel 37 befestigt sind, beispielsweise durch eine stoffschlüssige Verbindung und/oder eine Haftverbindung. Die Rahmenverbindungen 39 erstrecken sich beim Ausführungsbeispiel rechtwinklig zu den Schenkeln 37 und den Querschenkeln 38 der Rippenrahmenteile 36.

Bei den hier veranschaulichten bevorzugten Ausführungsbeispielen erstrecken sich sämtliche Rahmenstreben 32 in einer Richtung x oder einer Richtung y oder einer Richtung z eines kartesischen Koordinatensystems. In Abwandlung hierzu könnte der Verstärkungsrahmen 30 auch wenigstens eine Rahmenstrebe 32 aufweisen, die sich schräg zur Richtung x und/oder schräg zur Richtung y und/oder schräg zur Richtung z des kartesischen Koordinatensystems erstreckt.

Zwischen dem Innenraum 13 und der Umgebung U kann ein Gasaustausch stattfinden. Es ist daher nicht auszuschließen, dass explosionsfähige Gase in den Innenraum 13 gelangen und dort durch eine im Innenraum 13 angeordnete Zündquelle zur Explosion gebracht werden. Der zünddurchschlagsichere Spalt 18 ist derart ausgebildet bzw. dimensioniert, dass heiße Gase, Lichtbögen, Flammen, Funken oder andere zündfähige Medien ausreichend gekühlt oder gelöscht werden, bevor sie ausgehend vom Innenraum 13 in die Umgebung U gelangen. Dadurch ist sichergestellt, dass eine Zündung der explosionsgefährdeten Atmosphäre in der Umgebung U um das explosionsgeschützte Gehäuse 10 herum vermieden ist. Durch den Verstärkungsrahmen 30 ist sichergestellt, dass sich der Gehäusekörper 11 nicht derart durch den Explosionsdruck verformt, dass die Zünddurchschlagsicherheit des zünddurchschlagsicheren Spaltes 18 aufgehoben wird. Dies wird insbesondere durch den Ringrahmenteil 31 sichergestellt, der unmittelbar benachbart zur Gehäuseöffnung 14 angeordnet ist. Der Gehäuseflansch 15 stützt sich am Ringrahmenteil 31 ab. Dadurch wird eine Beeinträchtigung des zünddurchschlagsicheren Spalts 18 im Falle einer Explosion im Innenraum 13 verhindert. Der Ringrahmenteil 31 kann durch eine oder mehrere Rippenrahmenteile 36 verstärkt werden, um eine Verformung des Ringrahmenteils 31 im Falle einer Explosion im Innenraum 13 zu vermeiden.

Bei den bisher beschriebenen bevorzugten Ausführungsbeispielen besteht eine Gasströmungsverbindung zwischen dem Innenraum 13 und der Umgebung U ausschließlich mittels des zünddurchschlagsicheren Spalts 18. In Abwandlung hierzu kann das explosionsgeschützte Gehäuse 10 optional wenigstens eine Druckentlastungseinrichtung 43 aufweisen, die schematisch in Figur 6 veranschaulicht ist. Mittels der wenigstens einen Druckentlastungseinrichtung 43 kann zwischen dem Innenraum 13 und der Umgebung U wenigstens ein zusätzlicher zünddurchschlagsicherer Gasströmungspfad P bereitgestellt werden. Beispielsweise kann die Druckentlastungseinrichtung 43 durch einen Einsatz gebildet sein, der im Deckel 17 oder einer Gehäusewand 12 des Gehäusekörpers 11 angeordnet ist. Zur Herstellung der Zünddurchschlagsicherheit des Gasströmungspfades P kann die Druckentlastungseinrichtung 43 beispielsweise einen gasdurchlässigen porösen Körper 44 aufweisen. Auch andere Ausgestaltungen von Druckentlastungseinrichtungen 43 können verwendet werden, wie sie bei explosionsgeschützten Gehäusen an sich bekannt sind. Durch die wenigstens eine Druckentlastungseinrichtung 43 kann der Explosionsdruck im Innenraum 13 zusätzlich begrenzt werden.

Der wenigstens eine Gasströmungspfad P der wenigstens einen Druckentlastungseinrichtung 43 verläuft nicht durch eine Rahmenstrebe 32 des Verstärkungsrahmens 30, sondern in Bereichen zwischen Rahmenstreben 32 des Verstärkungsrahmens 30. Somit sind sämtliche Teile des Verstärkungsrahmens 30 frei von Abschnitten des wenigstens einen zünddurchschlagsicheren Gasströmungspfades P.

Bei den hier beschriebenen Ausführungsbeispielen ist das explosionsgeschützte Gehäuse 10 in der Zündschutzart druckfeste Kapselung (Ex d) ausgebildet. Das explosionsgeschützte Gehäuse 10 könnte alternativ auch in anderen normierten Zündschutzarten ausgebildet sein.

Die Erfindung betrifft ein explosionsgeschütztes Gehäuse 10 mit einem Gehäusekörper 11, der einen Innenraum 13 begrenzt und eine Gehäuseöffnung 14 aufweist. Mittels eines Deckels 17 kann die Gehäuseöffnung 14 verschlossen werden. In der Schließstellung des Deckels 17 ist zwischen dem Gehäusekörper 11 und insbesondere einem Gehäuseflansch 15 des Gehäusekörpers 11 und dem Deckel 17 ein zünddurchschlagsicherer Spalt 18 gebildet. Der Gehäusekörper 11 weist mehrere Gehäusewände 12 auf, die eine derart geringe Wandstärke s haben, dass die Gehäusewände 12 einem Explosionsdruck im Innenraum 13 nicht standhalten würden. Der Gehäusekörper 11 ist deswegen durch einen außerhalb des Innenraums 13 angeordneten Verstärkungsrahmen 30 verstärkt. Der Verstärkungsrahmen 30 weist ein Ringrahmenteil 31 auf, das benachbart zur Gehäuseöffnung 14 angeordnet ist und den Gehäusekörper 11 vollständig ringförmig umschließt. Insbesondere schließt sich das Ringrahmenteil 31 unmittelbar an den Gehäuseflansch 15 an.

### Bezugszeichenliste:

- 10: explosionsgeschütztes Gehäuse
- 11: Gehäusekörper
- 12: Gehäusewand
- 12a: Seitenwand
- 12b: Rückwand
- 13: Innenraum
- 14: Gehäuseöffnung
- 15: Gehäuseflansch
- 16: erste Begrenzungsfläche
- 17: Deckel
- 18: zünddurchschlagsicherer Spalt
- 19: Randbereich
- 20: zweite Begrenzungsfläche

- 30: Verstärkungsrahmen
- 31: Ringrahmenteil
- 32: Rahmenstrebe

- 36: Rippenrahmenteil
- 37: Schenkel
- 38: Querschenkel
- 39: Rahmenverbindung

- 43: Druckentlastungseinrichtung
- 44: poröser Körper

- d: Dicke des Deckels
- P: Gasströmungspfad
- r: Rahmenwandstärke
- s: Wandstärke
- U: Umgebung

## Patentansprüche

1. Explosionsgeschütztes Gehäuse (10)
mit einem Gehäusekörper (11), der einen Innenraum (13) begrenzt, und der eine Gehäuseöffnung (14) aufweist, durch die Zugang zum Innenraum (13) erlangt werden kann,
mit einem separaten Verstärkungsrahmen (30), der lösbar oder unlösbar außen am Gehäusekörper (11) angeordnet ist und einen Ringrahmenteil (31) aufweist, der den Gehäusekörper (11) benachbart zur Gehäuseöffnung (14) vollständig ringförmig umschließt,
mit einem Deckel (17), der in einer Schließstellung derart am Gehäusekörper (11) anliegt, dass zwischen dem Deckel (17) und dem Gehäusekörper (11) ein zünddurchschlagsicherer Spalt (18) gebildet ist.

2. Explosionsgeschütztes Gehäuse nach Anspruch 1,
**dadurch gekennzeichnet, dass** wenigstens eine Druckentlastungseinrichtung (43) vorhanden ist, die wenigstens einen zünddurchschlagsicheren Gasströmungspfad (P) zwischen dem Innenraum (13) und einer Umgebung (U) außerhalb des Gehäuses (10) bildet.

3. Explosionsgeschütztes Gehäuse nach Anspruch 2,
**dadurch gekennzeichnet, dass** der Verstärkungsrahmen (30) frei ist von Abschnitten des wenigstens einen zünddurchschlagsicheren Gasströmungspfads (P).

4. Explosionsgeschütztes Gehäuse nach Anspruch 1,
**dadurch gekennzeichnet, dass** eine Gasströmungsverbindung zwischen dem Innenraum (13) und einer Umgebung (U) außerhalb des Gehäuses (10) ausschließlich durch den zünddurchschlagsicheren Spalt (18) gebildet ist.

5. Explosionsgeschütztes Gehäuse nach einem der vorhergehenden Ansprüche,
**dadurch gekennzeichnet, dass** der Verstärkungsrahmen (30) wenigstens einen mit dem Ringrahmenteil (31) verbundenen Rippenrahmenteil (36) aufweist, das sich außerhalb einer durch das Ringrahmenteil (31) definierten Ebene erstreckt.

6. Explosionsgeschütztes Gehäuse nach Anspruch 5,
**dadurch gekennzeichnet, dass** zumindest ein Rippenrahmenteil (36) von dem wenigstens einen Rippenrahmenteil (36) zwei Schenkel (37) aufweist, die sich mit Abstand zueinander erstrecken und jeweils mit dem Ringrahmenteil (31) verbunden sind, und dass der Rippenrahmenteil (36) einen Querschenkel (38) aufweist, der sich mit Abstand zum Ringrahmenteil (31) erstreckt und der die beiden Schenkel (37) miteinander verbindet.

7. Explosionsgeschütztes Gehäuse nach Anspruch 6,
**dadurch gekennzeichnet, dass** wenigstens einer der beiden Schenkel (37) und/oder der Querschenkel (38) des wenigstens einen Rippenrahmenteils (36) am Gehäusekörper (11) anliegt.

8. Explosionsgeschütztes Gehäuse nach einem der Ansprüche 5 bis 7,
**dadurch gekennzeichnet, dass** mehrere Rippenrahmenteile (36) vorhanden sind, die sich parallel zueinander erstrecken und mit Abstand zueinander angeordnet sind.

9. Explosionsgeschütztes Gehäuse nach einem der vorhergehenden Ansprüche,
**dadurch gekennzeichnet, dass** der wenigstens eine Rippenrahmenteil (36) jeweils aus mehreren miteinander verbundenen Rahmenstreben (32) gebildet ist.

10. Explosionsgeschütztes Gehäuse nach einem der vorhergehenden Ansprüche,
**dadurch gekennzeichnet, dass** der Ringrahmenteil (31) jeweils aus mehreren miteinander verbundenen Rahmenstreben (32) gebildet ist.

11. Explosionsgeschütztes Gehäuse nach Anspruch 9 oder 10, **dadurch gekennzeichnet, dass** die jeweils unmittelbar benachbarten Rahmenstreben (32) mit ihren Enden aneinander anliegen.

12. Explosionsgeschütztes Gehäuse nach einem der Ansprüche 9 bis 11,
**dadurch gekennzeichnet, dass** die jeweils unmittelbar benachbarten Rahmenstreben (32) unlösbar miteinander verbunden sind.

13. Explosionsgeschütztes Gehäuse nach einem der vorhergehenden Ansprüche,
**dadurch gekennzeichnet, dass** der Gehäusekörper (11) einen Gehäuseflansch (15) aufweist und dass der zünddurchschlagsichere Spalt (18) zwischen dem Deckel (17) und dem Gehäuseflansch (15) gebildet ist.

14. Explosionsgeschütztes Gehäuse nach Anspruch 13,
**dadurch gekennzeichnet, dass** sich der Gehäuseflansch (15) vollständig um die Gehäuseöffnung (14) herum erstreckt.

15. Explosionsgeschütztes Gehäuse nach Anspruch 13 oder 14, **dadurch gekennzeichnet, dass** sich der Gehäuseflansch (15) am Ringrahmenteil (31) abstützt.

## Claims

1. Explosion-proof housing (10)
having a housing body (11) that delimits an interior (13) and that comprises a housing opening (14) through which the interior (13) is accessible,
having a separate reinforcing frame (30) that is releasably or non-releasably arranged on the outside of housing body (11) and comprises a ring frame part (31) that completely surrounds the housing body (11) in a ring-shaped manner adjacent to housing opening (14),
having a cover (17) that abuts against the housing body (11) in a closing position, such that a flameproof gap (18) is formed between cover (17) and housing body (11).

2. Explosion-proof housing according to claim 1, **characterized in that** at least one pressure relief device (43) is provided that forms at least one flameproof gas flow path (P) between the interior (13) and an environment (U) outside of housing (10).

3. Explosion-proof housing according to claim 2, **characterized in that** the reinforcing frame (30) is free of sections of the at least one flameproof gas flow path (P).

4. Explosion-proof housing according to claim 1, **characterized in that** a gas flow connection between the interior (13) and an environment (U) outside of housing (10) is exclusively provided by the flameproof gap (18).

5. Explosion-proof housing according to any of the preceding claims, **characterized in that** the reinforcing frame (30) comprises at least one rib frame part (36) that is connected with the ring frame part (31) and that extends outside of a plane defined by ring frame part (31).

6. Explosion-proof housing according to claim 5, **characterized in that** at least one rib frame part (36) of the at least one rib frame part (36) comprises two legs (37) that extend with distance to one another and that are respectively connected with the ring frame part (31), and that the rib frame part (36) comprises a transverse leg (38) that extends with distance to the ring frame part (31) and that connects the two legs (37) with each other.

7. Explosion-proof housing according to claim 6, **characterized in that** at least one of the two legs (37) and/or the transverse leg (38) of the at least one rib frame part (36) abuts against the housing body (11).

8. Explosion-proof housing according to any of the claims 5-7, **characterized in that** multiple rib frame parts (36) are present that extend parallel to each other and that are arranged with distance to each other.

9. Explosion-proof housing according to any of the preceding claims, **characterized in that** the at least one rib frame part (36) is made respectively from multiple frame struts (32) connected with each other.

10. Explosion-proof housing according to any of the preceding claims, **characterized in that** the ring frame part (31) is respectively made from multiple frame struts (32) connected with each other.

11. Explosion-proof housing according to claim 9 or 10, **characterized in that** the respective directly adjacent frame struts (32) abut each other with their ends.

12. Explosion-proof housing according to any of the claims 9-11, **characterized in that** the respective directly adjacent frame struts (32) are non-releasably connected with each other.

13. Explosion-proof housing according to any of the preceding claims, **characterized in that** the housing body (11) comprising a housing flange (15) and that the flameproof gap (18) is formed between the cover (17) and the housing flange (15).

14. Explosion-proof housing according to claim 13, **characterized in that** the housing flange (15) extends completely around the housing opening (14).

15. Explosion-proof housing according to claim 13 or 14, **characterized in that** the housing flange (15) is supported on the ring frame part (31).

## Revendications

1. Boîtier antidéflagrant (10)
comprenant un corps de boîtier (11) qui délimite un espace intérieur (13) et qui présente une ouverture de boîtier (14) à travers laquelle il est possible d'accéder à l'espace intérieur (13),
comprenant un châssis de renforcement (30) séparé qui est disposé de manière amovible ou inamovible à l'extérieur sur le corps de boîtier (11) et présente un élément de châssis périphérique (31) qui entoure le corps de boîtier (11) complètement sous une forme périphérique, à proximité de l'ouverture de boîtier (14),
comprenant un couvercle (17) qui, dans une position de fermeture, est appliqué contre le corps de boîtier (11) de manière à former un joint antidéflagrant (18) entre le couvercle (17) et le corps de boîtier (11).

2. Boîtier antidéflagrant selon la revendication 1, **caractérisé en ce qu'**il est prévu au moins un dispositif de décompression (43) qui forme au moins un chemin d'écoulement de gaz (P) antidéflagrant entre l'espace intérieur (13) et un environnement (U) à l'extérieur du boîtier (10).

3. Boîtier antidéflagrant selon la revendication 2, **caractérisé en ce que** le châssis de renforcement (30) est dépourvu de portions du chemin d'écoulement de gaz (P) antidéflagrant, au nombre d'au moins un.

4. Boîtier antidéflagrant selon la revendication 1, **caractérisé en ce qu'**une communication d'écoulement de gaz entre l'espace intérieur (13) et un environnement (U) à l'extérieur du corps de boîtier (11) est constituée exclusivement du joint antidéflagrant (18).

5. Boîtier antidéflagrant selon une des revendications précédentes, **caractérisé en ce que** le châssis de renforcement (30) présente au moins un élément de châssis formant étrier (36) qui est relié à l'élément de châssis périphérique (31) et s'étend à l'extérieur d'un plan défini par l'élément de châssis périphérique (31).

6. Boîtier antidéflagrant selon la revendication 5, **caractérisé en ce qu'**au moins un élément de châssis formant étrier (36) parmi les éléments de châssis formant étriers (36), au nombre d'au moins un, présente deux branches (37) qui s'étendent à distance l'une de l'autre et sont chacune reliées à l'élément de châssis périphérique (31), et **en ce que** l'élément de châssis formant étrier (36) présente une branche transversale (38) qui s'étend à distance de l'élément de châssis périphérique (31) et qui relie les deux branches (37) entre elles.

7. Boîtier antidéflagrant selon la revendication 6, **caractérisé en ce qu'**au moins une des deux branches (37) et/ou la branche transversale (38) de l'élément de châssis formant étrier (36), au nombre d'au moins un, est/sont appliquée(s) contre le corps de boîtier (11).

8. Boîtier antidéflagrant selon une des revendications 5 à 7, **caractérisé en ce qu'**il est prévu plusieurs éléments de châssis formant étriers (36) qui s'étendent parallèlement les uns aux autres et sont disposés à distance les uns des autres.

9. Boîtier antidéflagrant selon une des revendications précédentes, **caractérisé en ce que** l'élément de châssis formant étrier (36), au nombre d'au moins un, est constitué respectivement de plusieurs tiges de châssis (32) reliées entre elles.

10. Boîtier antidéflagrant selon une des revendications précédentes, **caractérisé en ce que** l'élément de châssis périphérique (31) est constitué respectivement de plusieurs tiges de châssis (32) reliées entre elles.

11. Boîtier antidéflagrant selon la revendication 9 ou 10, **caractérisé en ce que** les tiges de châssis (32) directement adjacentes sont appliquées les unes contre les autres avec leurs extrémités.

12. Boîtier antidéflagrant selon une des revendications 9 à 11, **caractérisé en ce que** les tiges de châssis (32) directement adjacentes sont reliées les unes aux autres de façon inamovible.

13. Boîtier antidéflagrant selon une des revendications précédentes, **caractérisé en ce que** le corps de boîtier (11) présente un rebord de boîtier (15) et **en ce que** le joint antidéflagrant (18) est formé entre le couvercle (17) et le rebord de boîtier (15).

14. Boîtier antidéflagrant selon la revendication 13, **caractérisé en ce que** le rebord de boîtier (15) s'étend entièrement autour de l'ouverture de boîtier (14).

15. Boîtier antidéflagrant selon la revendication 13 ou 14, **caractérisé en ce que** le rebord de boîtier (15) est en appui sur l'élément de châssis périphérique (31).
